# EUROPÄISCHE PATENTSCHRIFT

(11) **EP 1 116 278 B1**
(45) Veröffentlichungstag und Bekanntmachung des Hinweises auf die Patenterteilung: **13.06.2012**
(21) Anmeldenummer: 99955792.9
(22) Anmeldetag: 20.09.1999
(51) Int. Cl.: H01L 29/737, H01L 21/331, H01L 29/732

(54) **BIPOLARTRANSISTOR UND VERFAHREN ZU SEINER HERSTELLUNG**
BIPOLAR TRANSISTOR AND METHOD FOR PRODUCING SAME
TRANSISTOR BIPOLAIRE ET SON PROCEDE DE FABRICATION

(30) Priorität: 21.09.1998 DE 19845789
(43) Veröffentlichungstag der Anmeldung: 18.07.2001
(73) Patentinhaber: IHP GmbH-Innovations for High Performance Microelectronics / Leibniz-Institut für innovative Mikroelektronik, 15236 Frankfurt / Oder (DE)
(72) Erfinder: DREWS, Jürgen, D-15232 Frankfurt (Oder) (DE); TILLACK, Bernd, D-15234 Frankfurt (Oder) (DE); HEINEMANN, Bernd, D-15234 Frankfurt (Oder) (DE); KNOLL, Dieter, D-15230 Frankfurt (Oder) (DE)
(74) Vertreter: Eisenführ, Speiser & Partner
(86) Internationale Anmeldenummer: PCT/DE1999/003073
(87) Internationale Veröffentlichungsnummer: WO 2000/017934

(56) Entgegenhaltungen:
- WO-A-90/09678
- US-A- 5 137 840
- US-A- 5 604 374
- US-A- 5 668 396

## Beschreibung

Die Erfindung bezieht sich auf einen Bipolartransistor sowie auf ein Verfahren zu seiner Herstellung.

Ein wichtiges Einsatzgebiet vertikaler Bipolartransistoren sind Hochgeschwindigkeitsanwendungen. Um die Leistungsfähigkeit der Transistoren im Bereich höchster Geschwindigkeiten zu verbessern, ist der Einfluß parasitärer Komponenten, d. h. Widerständen oder Kapazitäten, zu reduzieren. Daher sind möglichst leitfähige Verbindungen zwischen den Metallkontakten und der aktiven (inneren) Transistorregion, aber auch eine minimierte passive Transistorfläche erforderlich.

Um diese Forderungen zu erfüllen, werden lateral skalierte, sogenannte "Doppel-Poly-Silizium-Technologien" in modernen Verfahren zur Herstellung von vertikalen Bipolartransistoren eingesetzt. In solchen Technologien ist es möglich, den Basiskontakt und Teile der hochleitfähigen Poly-Silizium Verbindung zwischen Kontakt und innerer Basis über isolierten Gebieten anzuordnen. Allerdings sind diese konstruktiven Vorteile gegenüber "Einfach-Poly-Silizium-Technologien" mit solchen Nachteilen wie zusätzlicher Prozeßkomplexität und erhöhten Kontaktwiderständen verbunden. Diese Nachteile stehen im Zusammenhang mit der erforderlichen Ätzung des Poly-Siliziums im aktiven Transistorbereich sowie der Diffusion von Dotanden aus der hochdotierten Poly-SiliziumSchicht in das einkristalline Basisanschlußgebiet. Da das Poly-Silizium für den Basisanschluß über dem aktiven Transistorgebiet mit Hilfe von Trockenätztechniken entfernt wird und keine Selektivität zum darunterliegenden einkristallinen Silizium besteht, kommt es zu Schädigungen der freigelegten Silizium-Oberfläche. Oberflächenrauhigkeit, Störungen der Gitterstruktur und Eindringen von Fremdstoffen sind die Folge.

Es sind verschiedene Ansätze vorgestellt worden, um diese Probleme zu überwinden.

Zum Beispiel werden Ätzstoppschichten zum Schutz der Emitterregion eingesetzt, um Probleme beim Trockenätzen zu lösen. Zusätzlicher Aufwand ist nötig, um eine Selbstjustage von Emittergebiet und Ätzstoppschicht zu gewährleisten.

Durch den Einsatz epitaktischer Prozesse konnten neuerdings die Hochgeschwindigkeitseigenschaften weiter verbessert werden. Dabei wird die in-situ Dotierung während der Abscheidung genutzt, um geringere Basisweiten, d. h. geringere Dicken der Basisschichten und geringere Basisschichtwiderstände, zu erreichen.

Einen zusätzlichen Freiheitsgrad bei der Einstellung von Basisschichtwiderstand und Stromverstärkung und damit zur Optimierung der Hochgeschwindigkeitseigenschaften gewinnt man durch die Abscheidung von Heteroschichten.

Das Konzept einer Doppel-Poly-Silizium-Technologie mit Ätzstoppschicht ist auch im Falle epitaktisch eingebrachter Basisschichten mit Hilfe der sogenannten selektiven Epitaxie verwirklicht worden. Bei der selektiven Epitaxie wird durch die Abscheidebedingungen sichergestellt, daß nur auf unbedeckten Halbleiteroberflächen epitaktisches Wachstum eintritt. Verwendet man differentielle Epitaxie, bei der Siliziummaterial sowohl auf Halbleiter- als auch auf Isolationsgebieten abgeschieden wird, können gleichzeitig die innere Basis und die Verbindung zu einem auf Isolatorgebiet befindlichen Basiskontakt (Basisanschlußgebiet) erzeugt werden. Damit entfällt im allgemeinen die Notwendigkeit für eine zusätzliche Poly-Silizium-Schicht. Die resultierende quasi Doppel-Poly-Silizium-Anordnung erlaubt, den Prozeß zu vereinfachen.

Gegenüber einem vollständigen Doppel-Poly-Prozeß ist man jedoch mit dem Nachteil konfrontiert, daß man die Dicke der Epitaxieschicht im aktiven Transistorgebiet nicht unabhängig von der Dicke der Siliziumschicht im Basisanschlußgebiet bzw. auf den Isolationsgebieten einstellen kann. Bezüglich der Epitaxieschichtdicke bestehen nämlich zwei unterschiedliche Forderungen. Und zwar sollte innerhalb des aktiven Emitterbereiches eine hinreichend geringe Schichtdicke zwischen dem hochdotierten Emitter und der Basis vorhanden sein. Im äußeren Basisgebiet ist eine größere Dicke von Vorteil, um geringe Widerstände des Basisanschlusses zu ermöglichen. Um diese gegensätzlichen Forderungen gleichzeitig zu erfüllen, bietet sich bevorzugt die Vergrößerung der Epitaxie-Schichtdicke über der Basis (Deckeldicke) in Verbindung mit einer selektiven Implantation im aktiven Emitterbereich an. Ohne besondere Maßnahmen führt das Ausheilen von Implantationsschäden jedoch, z.B. bei epitaktisch erzeugten Basisdotierungen in einer Silizium-Germanium- Schicht, zu einer unakzeptablen Verbreiterung des Basisprofils. Dotiert man die Deckelschicht in-situ, ergeben sich für die üblicherweise benutzten Poly-Emitter-Konstruktionen unerwünschte Konsequenzen: In der Regel entsteht unter der Passivierung zwischen dem Emitterrand und dem hochdotierten Basisanschluß eine schwächer leitende Emitterzone oder sogar eine Verarmung an Ladungsträgern. Dies kann sowohl statische als auch dynamische Eigenschaften des Transistors verschlechtern. Eine dickere Pufferschicht zwischen Substrat und Basis kann teilweise Abhilfe schaffen, wenn während der Epitaxie in-situ eine Dotierung vom Typ der Kollektordotierung eingebracht wird.

Neben prozeßtechnischen Schwierigkeiten hat diese Variante u. U. den Nachteil, daß eine spätere Umdotierung der Pufferschicht außerhalb des aktiven Transistors die Basis-Kollektor-Kapazität erhöht.

Aus der EP 0 483 487. B1 ist ein Bipolartransistor bekannt, bei dem in einem selbstjustierenden Doppel-Polysilizium-Prozeß eine Basisschicht mittels Niedertemperatur-Epitaxie hergestellt wird, wobei eine abgeschiedene Schichtfolge im aktiven Emitterbereich vollständig entfernt wird.

Aufgabe der Erfindung ist es, einen Bipolartransistor und ein Verfahren zu seiner Herstellung vorzuschlagen, bei dem für eine Einfach-Poly-Silizium-Technologie mit differentieller Epitaxie zur Basisherstellung die beschriebenen Nachteile konventioneller Anordnungen überwunden werden, um insbesondere die Hochgeschwindigkeitseigenschaften eines Bipolartransistors weiter zu verbessern, möglichst leitfähige Verbindungen zwischen den Metallkontakten und der aktiven (inneren) Transistorregion als auch eine minimierte passive Transistorfläche herzustellen, gleichzeitig zusätzliche Prozeßkomplexität und erhöhte Kontaktwiderstände zu vermeiden.

Erfindungsgemäß wird diese Aufgabe durch die Verfahren des Anspruchs 1 und durch einen Bipolartransistor gemäß Anspruch 6 gelöst.

Ein Einfach-Poly-Silizium-Bipolartransistor mit epitaktisch hergestellter Basis gemäß der Erfindung erlaubt eine Reduktion der externen Basiswiderstände, ohne eine Verschlechterung der Emittereigenschaften in Kauf nehmen zu müssen. Bedingt durch die unterbrechungsfreie Abscheidung von innerem und äußerem Basisgebiet treten keine Grenzflächenprobleme beim Basisanschluß auf. Außerdem kann die Basis-Kollektor-Kapazität gesenkt werden. Weitere Vorteile bietet eine zusätzliche in-situ Dotierung oder Hetero-Schichtfolge im Deckel über der abgeschiedenen Basisschicht. Als Ätzstoppschichten bewirken solche Zwischenschichten einen Ausgleich von Dickenschwankungen des Deckels im aktiven Emitterbereich.

Eine zweckmäßige Dotierung der Deckelschicht vom Leitungstyp der Basis, die im aktiven Emitter bei der Rückätzung des Deckels nur teilweise entfernt wird, führt zu einer Reduktion des externen Basiswiderstandes. Die selbstjustierende Anordnung ermöglicht einen niederohmigen, implantationsschadenfreien Basisanschluß bis hin zu sehr geringen Emitterbreiten. Außerdem läßt diese Art der zusätzlichen Dotierung des Basisanschlusses engere Abstände zwischen dem aktiven Emitterbereich und einer Silizierung des Basisanschlusses zu.

Die Merkmale der Erfindung gehen aus den Ansprüchen hervor, wobei die einzelnen Merkmale jeweils für sich allein oder zu mehreren in Form von Unterkombinationen schutzfähige Ausführungen darstellen, für die hier Schutz beansprucht wird. Ausführungsbeispiele der Erfindung sind in den Zeichnungen dargestellt und werden im folgenden näher erläutert.

Die Zeichnungen zeigen:
- Fig. 1: Schematische Darstellung eines Bipolartransistors
- Fig. 2: Schematische Darstellung eines Bipolartransistors nach Fig. 1 vor der Epitaxie
- Fig. 3: Schematische Darstellung eines Bipolartransistors nach Fig. 1 während der Herstellung
- Fig. 4: Schematische Darstellung eines Bipolartransistors
- Fig. 5: Schematische Darstellung eines Bipolartransistors nach Fig. 4 während der Herstellung
- Fig. 6: Schematische Darstellung eines Bipolartransistors nach Fig. 4 während der Herstellung

### Beispiel 1:

Die Erfindung wird nun im Zusammenhang mit einem Einfach-Poly-Silizium-Prozeß mit epitaktisch erzeugter Basis beschrieben. Modifikationen dieses Prozesses, wie z.B. Hetero-Epitaxie, oder die Einbindung in eine Bipolar-CMOS-(BiCMOS)-Technologie sind ebenfalls möglich.

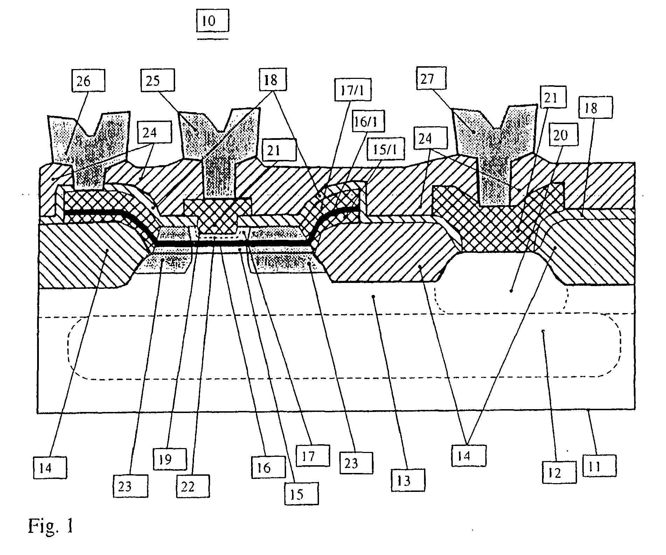

Fig. 1 zeigt schematisch einen Bipolartransistor **10** gemäß der Erfindung. Auf dem halbleitenden Substratgebiet **11** vom Leitfähigkeitstyp I ist ein Kollektorgebiet vom Leitfähigkeitstyp II erzeugt worden. Sind Emitter und Kollektor z.B. n-leitend, ist die Basis vom p-Typ bzw. umgekehrt. Es sind mehrere Verfahren bekannt, die eine geeignete Kollektordotierung liefern. Dazu zählen zum Beispiel der in Fig. 1 gezeigte Aufbau mit einer hochdotierten, vergrabenen Schicht **12** und einer schwächer dotierten Epitaxieschicht **13**, aber auch implantierte retrograde Wannen. Feldisolationsgebiet **14** trennt im hier dargestellten Beispiel den Bipolartransistor von anderen, in der Fig. nicht dargestellten Bauelementen und auch den Kollektoranschlußbereich vom aktiven Transistorgebiet. Es sind auch andere geeignete Isolationstechniken bekannt, wie z.B. verspacerte Mesa-Anordnungen. Wahlweise kann ein Schachtimplant **20** eingesetzt werden, um den Widerstand zwischen der aus hochdotiertem Poly-Silizium bestehenden Kontaktschicht **21** und der vergrabenen Schicht **12** zu verringern.

Eine Epitaxieschichtfolge, bestehend aus Pufferschicht **15**, in-situ dotierter Basisschicht **16** vom Leitfähigkeitstyp **I** sowie der Deckelschicht **17**, bedeckt die Emitterregion im aktiven Transistorbereich und mindestens einen Teil des Isolationsgebietes. Die außerhalb des aktiven Transistorgebietes strukturierte Epitaxieschicht ist mit einem Dielektrikum **18** bedeckt.

Die Pufferschicht **15** ist möglich, aber nicht wesentlich für die vorliegende Erfindung. Die speziellen Werte für die Dicke, den Dotandengehalt sowie die Materialzusammensetzung der Basis sind entsprechend den Erfordernissen der Funktion des Bipolartransistors einzustellen und unterliegen bezüglich dem Wesen der Erfindung keinen besonderen Anforderungen. Im dargestellten Beispiel besteht die Basisschicht aus Silizium, ist mit 210¹⁸cm⁻³ p-dotiert und sei 40nm dick. Es können aber auch andere Materialkompositionen und Dotierungsprofile verwendet werden. Als wesentlich im Sinne der Erfindung ist der Einsatz einer Deckelschicht 17 über der Basisschicht. Sie ist nur teilweise im aktiven Emitterbereich abgetragen. Die Dotierung des Emitters im einkristallinen Silizium wird durch Ausdiffusion von Dotierstoff 22 aus der hochdotierten Poly-Silizium-Kontaktschicht 21 sichergestellt. Die abgeschiedene Dicke der Deckelschicht kann typischerweise 50 bis 150 nm betragen. Als bevorzugter Wert wird eine Dicke von 100 nm angenommen. Die genaue Tiefe des rückgeätzten Teils 19 der Deckelschicht 17 hängt von der Gestaltung der Basisdotierung und -materialzusammensetzung sowie des gewünschten Dotandenprofils am Basis-Emitter-Übergang ab. Im angegebenen Beispiel ist eine verbleibende Dicke der Deckelschicht von 50 nm vorgegeben. Während die Puffer-, Basis- und Deckelschicht einkristallin über dem Silizium-Substrat wachsen, entstehen polykristalline Schichten 15/1; 16/1; 17/1 über dem Isolationsgebiet 14. Außerhalb der den aktiven Transistorbereich überlappenden Poly-Silizium-Kontaktschicht 21 ist die Dotierung im Basisanschlußgebiet zusätzlich durch Implantation 23 vergrößert worden. Die Isolationsschicht 24 trennt Emitter-, Basis-, und Kollektorkontakt. Vervollständigt wird der Transistoraufbau durch Metallkontakte für Emitter 25, Basis 26 und Kollektor 27.

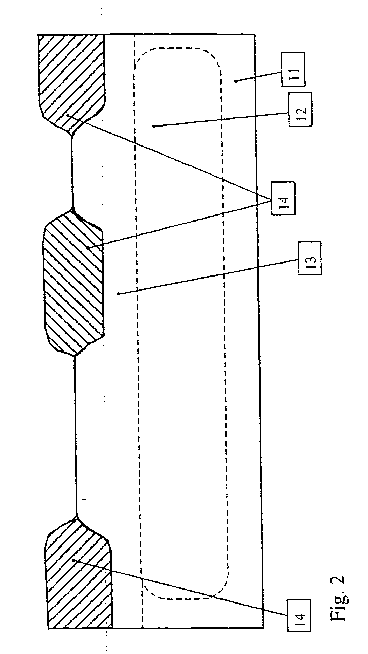

Im Folgenden wird die Herstellung eines Bipolartransistors gemäß der Erfindung dargelegt. Ausgangspunkt für das erfindungsgemäße Verfahren ist der in Fig. 2 dargestellte Aufbau vor der Epitaxie. In p-dotiertes Silizium-Substrat 11 wird nach photolithographischer Strukturierung eine hochdotierte n-Schicht 12 per Implantation eingebracht und ausgeheilt. Anschließend wird epitaktisch eine schwach dotierte n-Schicht 13 abgeschieden. Übliche Prozeßschritte definieren das aktive Gebiet und erzeugen in den verbleibenden Gebieten Isolationsgebiete 14 (z.B. LOCOS).

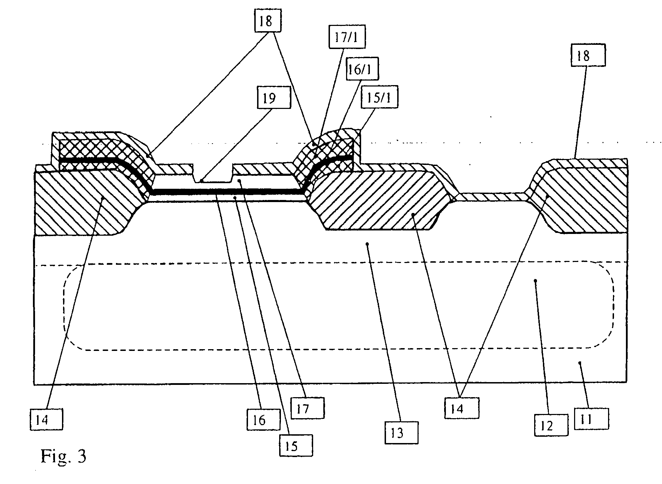

In Fig. 3 ist das Ergebnis der folgenden Prozeßschritte dargestellt. Mit Hilfe differentieller Epitaxie werden Pufferschicht 15; 15/1, Basisschicht 16; 16/1 und Deckelschicht 17; 17/1abgeschieden, die auf Silizium-Gebiet einkristallin und auf Isolationsgebiet polykristallin wachsen. Nach photolithographischer Strukturierung einer Maske werden mit Hilfe eines Plasmaätzschrittes außerhalb des späteren Transistor- und Basisanschlußgebietes die abgeschiedenen Silizium- bzw. Poly-Silizium-Schichten mit Ätzstopp auf dem Isolationsgebiet entfernt. Ein anschließend aufgebrachtes Dielektrikum 18, vorzugsweise Oxid, wird auf der Basis gewöhnlicher lithographischer und Naß-Ätzprozesse zunächst im Emittergebiet geöffnet.

Das in Fig. 3 abgebildete Oberflächenrelief kann mit Hilfe bekannter naßchemischer Ätzmittel, die Silizium gut steuerbar und hochselektiv zum maskierenden Dielektrikum entfernen, hergestellt werden. Dabei wird im aktiven Emittergebiet die Deckelschicht nur teilweise abgetragen. Das angestrebte Oberflächenrelief läßt sich aber auch erzeugen, wenn eine Nitridmaske über der abgeschiedenen Schichtfolge 15, 15/1; 16, 16/1; 17,17/1 über dem aktiven Emitter geöffnet wird, anschließend die Deckelschicht 17 nur teilweise bei einer thermischen Oxidation in SiO₂ umgewandelt wird und schließlich das im aktiven Emitter gebildete Oxid selektiv zur Maske und mit Ätzstopp auf dem einkristallinen Silizium naßchemisch entfernt wird. ,

Durch photolithographische Strukturierung einer Lackmaske wird nun das Kollektoranschlußgebiet freigelegt und der Schachtimplant eingebracht. Vor dem Entfernen dieser Lackmaske wird auch im Kollektoranschlußgebiet wie schon im Emitterbereich die Oxidschicht 18 vorzugsweise naßchemisch geätzt. Der Prozeß wird fortgesetzt mit der Abscheidung einer amorphen Siliziumschicht. Diese kann bereits in-situ während oder im Anschluß an die Abscheidung durch Implantation dotiert werden. Mit einem Lithographieschritt werden Emitter- und Kollektorkontaktgebiet maskiert. In den übrigen Gebieten wird das amorphe Silizium bei einem Plasmaätzschritt mit Stopp auf der SiO₂-Schicht entfernt. Bei der anschließenden Implantation der Basisanschlußgebiete werden

Emitter- und Kollektorkontaktgebiete durch die vorhandene Maskierung geschützt. Nach dem Entfernen dieser Maskierung und einer Abdeckung der entstandenen Oberfläche mit Oxid folgt eine Temperung zur Ausheilung der Implantationsschäden sowie zur Formierung des Poly-Emitters. Der Prozeß wird vervollständigt durch das Öffnen der Kontaktlöcher für Emitter, Basis und Kollektor und eine Standardmetallisierung für die Transistorkontakte.

### Beispiel 2:

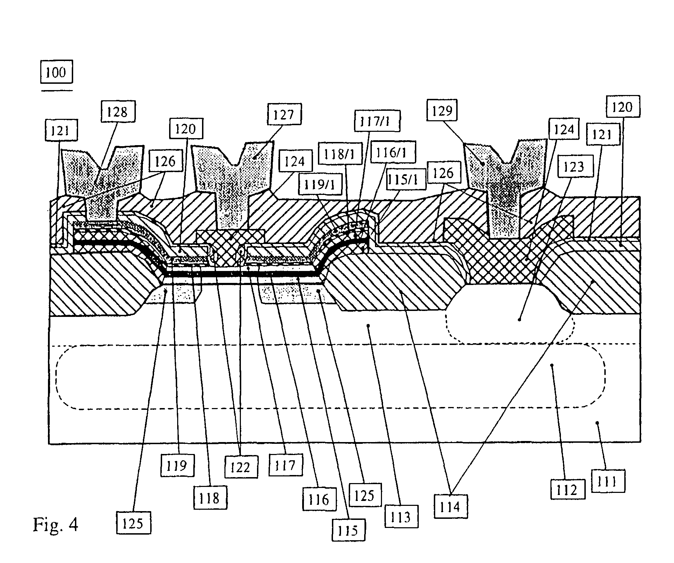

Fig. 4 zeigt schematisch ein zweites Ausführungsbeispiel eines Bipolartransistors **100** gemäß der Erfindung. Wie im ersten Ausführungsbeispiel ist auf dem halbleitenden Substratgebiet **111** vom Leitfähigkeitstyp I ein Kollektorgebiet vom Leitfähigkeitstyp II erzeugt worden. Die Kollektordotierung besteht aus einer hochdotierten, vergrabenen Schicht **112** und einer schwächer dotierten Epitaxieschicht **113**. Isolationsgebiet **114** trennt den Bipolartransistor von anderen, in der Fig. nicht dargestellten Bauelementen und auch den Kollektoranschlußbereich vom aktiven Transistorgebiet. Wahlweise kann ein Schachtimplant **123** eingesetzt werden, um den Widerstand zwischen der aus hochdotiertem Poly-Silizium bestehenden Kontaktschicht **124** und der vergrabenen Schicht **112** zu verringern.

Eine Epitaxieschichtfolge, bestehend aus Pufferschicht **115**, in-situ dotierter Basisschicht **116** vom Leitfähigkeitstyp I, der schwach dotierten Zwischenschicht **117**, einer Ätzstoppschicht **118** und schließlich einer vorzugsweise dotierten (mit dem Leitfähigkeitstyp der Basis) Deckelschicht **119**, bedeckt die Emitterregion im aktiven Transistorbereich und mindestens einen Teil des Isolationsgebietes. Während die Puffer-, Basis-, Zwischen-, Ätzstopp- und Deckelschicht einkristallin über dem Silizium-Substrat wachsen, entstehen polykristalline Schichten **115**/**1**; **116**/**1**; **117**/**1**; **118**/**1** und **119**/**1** über dem Isolationsgebiet **114**. Die außerhalb des aktiven Transistorgebietes strukturierte Epitaxieschicht ist mit einem Dielektrikum **120** bedeckt. Die Pufferschicht **115** ist möglich, aber nicht wesentlich für die vorliegende Erfindung. Die speziellen Werte für die Dicke, den Dotandengehalt sowie die Materialzusammensetzung der Basis sind entsprechend den Erfordernissen der Funktion des Bipolartransistors einzustellen und unterliegen bezüglich dem Wesen der Erfindung keinen besonderen Anforderungen. Beispielsweise kann eine stark bordotierte Silizium-Germanium-Schicht verwendet werden. Um die Ausdiffusion von Bor aus der Silizium-Germanium-Schicht zu verhindern, sei in die Basisschicht in geeigneter Weise Kohlenstoff eingebracht. Es können auch andere Materialkompositionen und Dotierungsprofile für die Basis verwendet werden.

Als wesentlich im Sinne der Erfindung ist der Einsatz der Schichtkombination **117**; **118** 9 und **119** über der Basischicht **116** anzusehen, wobei die Deckelschicht **119** vollständig und die Ätzstoppschicht **118** vollständig bzw. teilweise im aktiven Emitterbereich abgetragen werden. Unmittelbar über der Basis folgt eine schwach dotierte Zwischenschicht **117**. Die Dicke dieser Zwischenschicht ist so gewählt, daß Tunnelströme zwischen den Hochdotierungen von Basis und Emitter vermieden und die dynamischen Transistoreigenschaften vorteilhaft beeinflußt werden. Die Eigenschaften der darüberliegenden Ätzstoppschicht **118** und Deckelschicht **119** sind so ausgelegt, daß beim Ätzen der Deckelschicht **119** eine hinreichende Selektivität zur Stoppschicht **118** besteht. Außerdem ist die Ätzstoppschicht vorzugsweise so ausgebildet, daß sie in einem zweiten Ätzschritt selbst entfernt werden kann. Dadurch ist es möglich, die Ätzstoppschicht **118** ebenso wie die Deckelschicht **119** mit dem Leitfähigkeitstyp der Basis stark zu dotieren. Diese Bedingungen können z.B. erfüllt werden, wenn eine aus Silizium bestehende Ätzstoppschicht **118** sehr stark mit Bor, insbesondere größer 3·10¹⁹cm⁻³ und die darüberliegende Deckelschicht mit einer Borkonzentration kleiner als 10¹⁹cm-³ dotiert werden. Eine Ätzstoppwirkung gegenüber der Deckelschicht **119** kann auch durch andere Materialzusammensetzungen der Ätzstoppschicht **118**, wie z.B. mit Silizium-Germanium oder kohlenstoffreichem Silizium, erreicht werden.

Die abgeschiedene Dicke der Zwischenschicht **117** kann typischerweise 30 bis 50 nm betragen. Als bevorzugter Wert wird eine Dicke von 40 nm angenommen. Die Dicke der Ätzstoppschicht kann zwischen 5 und 15 nm liegen, bevorzugt wird ein Wert von 10 nm. Die Dicke der Deckelschicht kann Werte von 30 bis 100 nm annehmen, bevorzugt wird ein Wert von 50 nm. Ein ausreichender seitlicher Abstand zwischen den vorzugsweise eingesetzten Hochdotierungen von Ätzstoppschicht **118** und Deckelschicht **119** auf der einen Seite sowie der durch Ausdiffusion aus der hochdotierten Poly-Silizium-Kontaktschicht **124** gebildeten Emitterdotierung auf der anderen Seite wird durch die Formierung eines Inside-Poly-Silizium-Spacers **122** gewährleistet. Die SiO₂-Isolationsschicht **121** dient während der Herstellung des Inside-Spacers als Ätzstoppschicht für den erforderlichen Plasmaätzschritt. Außerhalb der den aktiven Transistorbereich überlappenden Poly-Silizium-Kontaktschicht **124** ist die Dotierung im Basisanschlußgebiet zusätzlich durch Implantation **125** vergrößert worden. Die von dieser Implantation herrührende beschleunigte Diffusion soll vorzugsweise dafür genutzt werden, eine Ausbreitung der in Deckelschicht **119** und Ätzstoppschicht **118** eingebrachten Dotierung in Richtung Basis zu bewirken, während eine Verbreiterung der inneren Basisschicht durch Kohlenstoffeinbau verhindert wird. Die Isolationsschicht **126** trennt Emitter-, Basis-, und Kollektorkontakt. Vervollständigt wird der Transistoraufbau durch Metallkontakte für Emitter **127**, Basis **128** und Kollektor **129**.

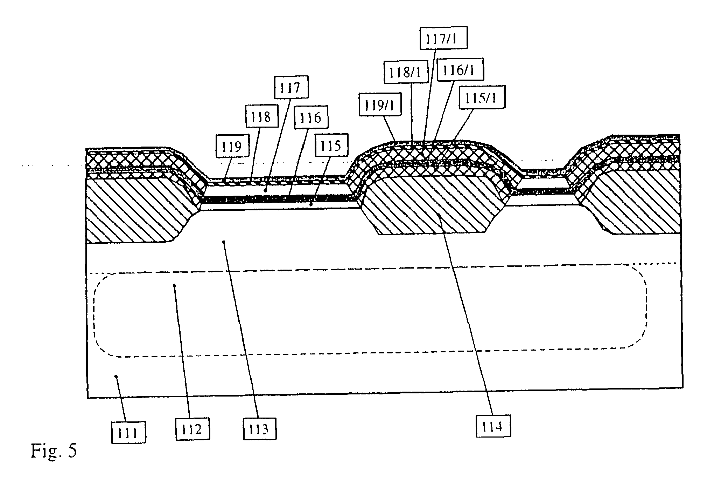

Im folgenden wird die Herstellung des in Fig. 4 gezeigten Bipolartransistors **100** gemäß der Erfindung dargelegt. Die Prozeßschritte bis zur differentiellen Epitaxie sind beim zweiten Ausführungsbeispiel mit den Schritten im ersten Ausführungsbeispiel identisch. Anstelle der im ersten Ausführungsbeispiel angegebenen Schichtfolge wird nun mit dem folgenden Schichtstapel fortgesetzt: Nach der Pufferschicht **115**; **115**/**1** und Basisschicht **116**; **116**/**1** folgen eine schwach dotierte Zwischenschicht **117**; **117**/**1**, eine Ätzstoppschicht **118**; **118**/**1** sowie eine Deckelschicht **119**; **119**/**1**. Auf Silizium-Gebiet findet einkristallines und auf Isolationsgebiet polykristallines Wachstum statt. Ausgangspunkt für die weiteren Schritte ist der in Fig. 5 dargestellte Aufbau.

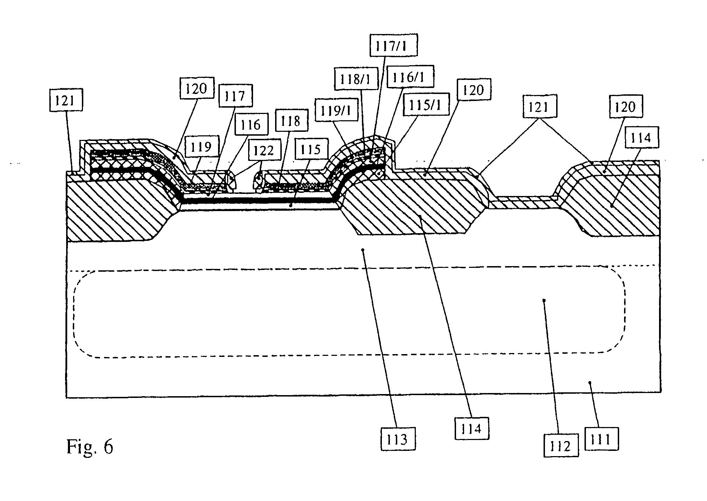

Nach photolithographischer Strukturierung einer Maske werden mit Hilfe eines Plasmaätzschrittes außerhalb des späteren Transistor- und Basisanschlußgebietes die abgeschiedenen Silizium- bzw. Poly-Silizium-Schichten mit Ätzstopp auf dem Isolationsgebiet **114** entfernt. Ein anschließend aufgebrachtes Dielektrikum **120** (Fig. 6), z.B. 50 nm Oxid, wird mit Hilfe gewöhnlicher lithographischer- und Naß-Ätzprozesse zunächst im Emittergebiet geöffnet.

Mit Hilfe bekannter naßchemischer Ätzmittel, die eine bordotierte Siliziumschicht gut steuerbar und ausreichend selektiv zur darunterliegenden Ätzstoppschicht bzw. zu SiO₂ entfernen, wird im aktiven Emittergebiet die Deckelschicht **119** vollständig bis zur Ätzstoppschicht **118** abgetragen. Vorzugsweise wird in einem weiteren Naßätzschritt auch die Ätzstoppschicht mit ausreichender Selektivität zu SiO₂ entfernt. Eine Selektivität zu der an den Seitenwänden freiliegenden Deckelschicht ist nicht erforderlich. Es folgt eine ganzflächige Abscheidung einer Doppelschicht, z. B. bestehend aus 20 nm SiO₂ und 100 nm amorphem Silizium. Nach einem Plasmaätzschritt mit Ätzstopp auf der zuletzt abgeschiedenen Oxidschicht entstehen Inside-Spacer. Anschließend wird in einem naßchemischen Ätzschritt die Siliziumoberfläche freigelegt.

Es entsteht das in Fig. 6 abgebildete Oberflächenrelief. Durch photolithographische Strukturierung einer Lackmaske wird nun das Kollektoranschlußgebiet geöffnet und der Schachtimplant eingebracht. Vor dem Entfernen dieser Lackmaske werden im Kollektoranschlußgebiet die Oxidschichten **120**; **121** vorzugsweise naßchemisch geätzt. Der Prozeß wird nun bis zum fertigen Transistor wie im ersten Ausführungsbeispiel fortgesetzt. In der vorliegenden Erfindung wurde anhand konkreter Ausführungsbeispiele ein Bipolartransistor und ein Verfahren zu seiner Herstellung erläutert. Es sei aber vermerkt, daß a im Rahmen der Patentansprüche Änderungen und Abwandlungen beansprucht werden.

## Patentansprüche

1. Verfahren zur Herstellung eines Bipolartransistors mit den Schritten:
- Erzeugung strukturierter Gebiete, bestehend aus einem Kollektorbereich (13; 113) und diesen umgebenden Isolationsgebieten (14;114) auf einer einkristallinen Substratschicht (11;111);
- Abscheiden einer Schichtfolge (15, 16, 17; 115, 116, 117, 118, 119), gleichzeitig über dem Kollektorbereich (13) einkristallin und über den Isolationsgebieten (14) polykristallin (15/1, 16/1, 17/1; 115/1, 116/1, 117/1, 118/1, 119/1), wobei die Schichtfolge (15, 16, 17; 115, 116, 117, 118, 119) eine Basisschicht, die über dem Kollektorbereich (13) einkristallin (16; 116) und über den Isolationsgebieten (14; 114) polykristallin (16/1; 116/1) ist, sowie in ihrem einkristallinen und in ihrem polykristallinen Bereich (15/1, 16/1, 17/1; 115/1, 116/1, 117/1, 118/1, 119/1)
a) entweder eine Deckelschicht (17, 17/1) oder
b) eine Schichtkombination (117, 118, 119; 117/1, 118/1, 119/1) mit einer Zwischenschicht (117, 117/1), einer Ätzstoppschicht (118, 118/1) und einer Deckelschicht (119, 119/1) enthält;
**gekennzeichnet durch**
- im Fall a): nur teilweises Entfernen der Deckelschicht (17) in einem für einen aktiven Emitterbereich vorgesehenen lateralen Gebiet (19) **durch** naßchemisches Ätzen;
- im Fall b) vollständiges Entfernen der Deckelschicht (119) und nur teilweises oder vollständiges Entfernen der Ätzstoppschicht (118), ohne dass die Zwischenschicht (117, 117/1) entfernt wird, in einem für einen aktiven Emitterbereich vorgesehenen lateralen Gebiet **durch** naßchemisches Ätzen.

2. Verfahren nach Anspruch 1, **dadurch gekennzeichnet, daß** eine zusätzliche Dotierung in die Deckelschicht (17) über die Basisschicht (16) eingebracht wird.

3. Verfahren nach Anspruch 2, **dadurch gekennzeichnet, daß** die zusätzlich in die Deckelschicht (17) eingebrachte Dotierung als Ätzstoppschicht für ein erstes naßchemisches Ätzmittel verwendet wird und erforderlichenfalls die Ätzstoppschicht mit einem zweiten naßchemischen Ätzmittel teilweise entfernt wird.

4. Verfahren nach einem der vorstehenden Ansprüche, **dadurch gekennzeichnet, daß** in die Basisschicht (16, 116) Kohlenstoff oder Sauerstoff als diffusionshemmendes Mittel für eine Basisdotierung eingebaut ist.

5. Verfahren nach alternative h) des Anspruchs 1, **dadurch gekennzeichnet, daß** die Basisschicht (116) p-dotiert wird, die an die Basisschicht (116) angrenzende Zwischenschicht (117) mit einer Konzentration kleiner 5 x 10¹⁸ cm⁻³ schwächer dotiert wird, daß über der Zwischenschicht (117) die Ätzstoppschicht (118) aus Silizium mit einer Bor-Konzentration von mehr als 1,5 x 10¹⁹ cm⁻³ hergestellt wird, daß anschließend die darüberliegende Deckelschicht (119) mit einer Bor-Konzentration von weniger als 1,5 x 10¹⁹ cm⁻³ hergestellt wird, daß anschließend die Deckelschicht (119) und die Ätzstoppschicht (118) unter Verwendung einer Maskierung im aktiven Emitterbereich vollständig abgetragen werden, daß danach eine Doppelschicht abgeschieden wird, und daß danach ein Inside-Spacer (122) so erzeugt wird, daß die einkristalline Zwischenschicht (117) naßchemisch freigelegt werden kann.

6. Bipolartransistor mit strukturierten Gebieten auf einer einkristallinen Substratschicht (11; 111), umfassend einen Kollektorbereich und diesen umgebende Isolationsgebiete (14; 114) sowie eine oberhalb des Kollektorbereichs angeordnete einkristalline Schichtfolge (15, 16, 17; 115, 116, 117, 118, 119), bei dem die einkristalline Schichtfolge eine Basisschicht (16, 116) und entmoder
a) eine darüberliegende Deckelschicht (17; 119) enthält und die Deckelschicht in einem aktiven Emitterbereich (19) teilweise abgetragen ist, oder b) über der Basisschicht (116) eine Schichtkombination, bestehend aus einer Zwischenschicht (117), einer Ätzstoppschicht (118) und einer Deckelschicht (119), angeordnet ist, wobei die Deckelschicht (119) vollständig und die Ätzstoppschicht (118) teilweise im aktiven Emitterbereich abgetragen ist.

7. Bipolartransistor nach Anspruch 6, **dadurch gekennzeichnet, daß** die abgeschiedene Dicke der Deckelschicht (17) zwischen 50 nm und 200 nm beträgt.

8. Bipolartransistor nach Anspruch 6 oder 7, **dadurch gekennzeichnet, daß** die verbleibende Dicke des rückgeätzten Teils (19) der Deckelschicht (17) zwischen 30 nm und 60 nm beträgt.

9. Bipolartransistor nach einem der Ansprüche 6 bis 8, **dadurch gekennzeichnet, daß** die Deckelschicht (17) teilweise oder vollständig mit einer Dotandenkonzentration kleiner 5 x 10¹⁸ cm⁻³ vom Leitungstyp der Basisschicht dotiert ist.

10. Bipolartransistor nach Anspruch 6 bis 9, **dadurch gekennzeichnet, daß** in die Basisschicht (116) Kohlenstoff oder Sauerstoff eingebracht ist.

11. Bipolartransistor nach Anspruch 9 oder 10, **dadurch gekennzeichnet, daß** die abgeschiedene Dicke der Zwischenschicht (117) zwischen 30 nm und 60 nm beträgt.

12. Bipolartransistor nach einem der Ansprüche 9 bis 11, **dadurch gekennzeichnet, daß** die Zwischenschicht (117) mit einer Dotandenkonzentration kleiner als 5 x 10¹⁸ cm⁻³ vom Leitungstyp der Basis dotiert ist.

13. Bipolartransistor nach einem der Ansprüche 9 bis 12, **dadurch gekennzeichnet, daß** die abgeschiedene Dicke der Ätzstoppschicht (118) zwischen 3 nm und 20 nm beträgt.

14. Bipolartransistor nach einem der Ansprüche 9 bis 13,**dadurch gekennzeichnet, daß** die abgeschiedene Dicke der Deckelschicht (119) zwischen 30 nm und 150 nm beträgt.

15. Bipolartransistor nach einem der Ansprüchen 9 bis 14, **dadurch gekennzeichnet, daß** die Ätzstoppschicht (118) aus SiGe oder SiC besteht.

16. Bipolartransistor nach einem der Ansprüche 9 bis 15, **dadurch gekennzeichnet, daß** die Ätzstoppschicht (118) oder Deckelschicht (119) aus einer stark mit dem Leitungstyp der Basis dotierten Siliziumschicht besteht.

17. Bipolartransistor nach einem der Ansprüche 9 bis 16, **dadurch gekennzeichnet, daß** die Basis p-leitend ist und die Ätzstoppschicht (118) mit einer Borkonzentration größer als 1,5 x 10¹⁹ cm⁻³ und die Deckelschicht mit einer Borkonzentration kleiner als 1,5 x 10¹⁹ cm⁻³ dotiert ist.

## Claims

1. Method of producing a bipolar transistor, comprising the steps of:
- producing structured areas consisting of a collector region (13; 113) and insulating regions (14; 114) surrounding it, on a monocrystalline substrate layer (11; 111);
- depositing a series of layers (15, 16, 17; 115, 116, 117, 118, 119), which are simultaneously monocrystalline over the collector region (13) and polycrystalline (15/1, 16/1, 17/1; 115/1, 116/1, 117/1, 118/1, 119/1) over the insulating regions (14), the series of layers (15, 16, 17; 115, 116, 117, 118, 119) containing a base layer which is monocrystalline (16; 116) over the collector region (13) and polycrystalline (16/1; 116/1) over the insulating regions (14; 114), and containing in its monocrystalline and in its polycrystalline region (15/1, 16/1, 17/1; 115/1, 116/1, 117/1, 118/1, 119/1)
a) either a covering layer (17, 17/1) or
b) a layer combination (117, 118, 119; 117/1, 118/1, 119/1) with an intermediate layer (117, 117/1), an etch stopping layer (118, 118/1) and a covering layer (119, 119/1);
**characterised by**
- in case a): only partial removal of the covering layer (17) in a lateral region (19) provided for an active emitter region by wet chemical etching;
- in case b): complete removal of the covering layer (119) and only partial or complete removal of the etch stopping layer (118), without the removal of the intermediate layer (117, 117/1), in a lateral region (19) provided for an active emitter region by wet chemical etching.

2. Method according to claim 1, **characterised in that** additional doping is introduced into the covering layer (17) through the base layer (16).

3. Method according to claim 2, **characterised in that** the doping additionally introduced into the covering layer (17) is used as an etch stopping layer for a first wet chemical etching agent and if necessary the etch stopping layer is partly removed with a second wet chemical etching agent.

4. Method according to one of the preceding claims, **characterised in that** carbon or oxygen is incorporated in the base layer (16, 116) as a diffusion-inhibiting agent for base doping.

5. Method according to alternative b) of claim 1, **characterised in that** the base layer (116) is p-doped, the intermediate layer (117) adjoining the base layer (116) is doped more weakly with a concentration of less than 5 x 10¹⁸ cm⁻³, above the intermediate layer (117) the etch stopping layer (118) is produced from silicon with a boron concentration of more than 1.5 x 10¹⁹ cm⁻³, subsequently the overlying covering layer (119) is produced with a boron concentration of less than 1.5 x 10¹⁹ cm⁻³, subsequently the covering layer (119) and the etch stopping layer (118) are totally removed using masking in the active emitter region, a double layer is then deposited, and an inside spacer (122) is then produced such that the monocrystalline intermediate layer (117) can be exposed by wet chemical means.

6. Bipolar transistor with structured regions on a monocrystalline substrate layer (11; 111), comprising a collector region and insulating regions (14; 114) surrounding it, and a monocrystalline layer sequence (15, 16, 17; 115, 116, 117, 118, 119), arranged above the collector region, wherein the monocrystalline layer sequence contains a base layer (16, 116) and either
a) contains an overlying covering layer (17; 119) and the covering layer has been partially removed in an active emitter region (19), or
b) over the base layer (116) is provided a layer combination consisting of an intermediate layer (117), an etch stopping layer (118) and a covering layer (119), wherein the covering layer (119) has been removed completely and the etch stopping layer (118) has been partially removed in the active emitter region.

7. Bipolar transistor according to claim 6, **characterised in that** the deposited thickness of the covering layer (17) is between 50 nm and 200 nm.

8. Bipolar transistor according to claim 6 or 7, **characterised in that** the remaining thickness of the part (19) of the covering layer (17) that has been etched back is between 30 nm and 60 nm.

9. Bipolar transistor according to one of claims 6 to 8, **characterised in that** the covering layer (17) has been partly or completely doped with a dopant concentration of less than 5 x 10¹⁸ cm⁻³ of the conductivity type of the base layer.

10. Bipolar transistor according to claims 6 to 9, **characterised in that** carbon or oxygen has been incorporated in the base layer (116).

11. Bipolar transistor according to claim 9 or 10, **characterised in that** the deposited thickness of the intermediate layer (117) is between 30 nm and 60 nm.

12. Bipolar transistor according to one of claims 9 to 11, **characterised in that** the intermediate layer (117) has been doped with a dopant concentration of less than 5 x 10¹⁸ cm⁻³ of the conductivity type of the base.

13. Bipolar transistor according to one of claims 9 to 12, **characterised in that** the deposited thickness of the etch stopping layer (118) is between 3 nm and 20 nm.

14. Bipolar transistor according to one of claims 9 to 13, **characterised in that** the deposited thickness of the covering layer (119) is between 30 nm and 150 nm.

15. Bipolar transistor according to one of claims 9 to 14, **characterised in that** the etch stopping layer (118) consists of SiGe or SiC.

16. Bipolar transistor according to one of claims 9 to 15, **characterised in that** the etch stopping layer (118) or covering layer (119) consists of a silicon layer highly doped with the conductivity type of the base.

17. Bipolar transistor according to one of claims 9 to 16, **characterised in that** the base is p-conductive and the etch stopping layer (118) is doped with a boron concentration of more than 1.5 x 10¹⁹ cm⁻³ and the covering layer is doped with a boron concentration of less than 1.5 x 10¹⁹ cm⁻³.

## Revendications

1. Procédé de fabrication d'un transistor bipolaire comprenant les étapes suivantes :
- la création de zones structurées, constituées d'une zone collectrice (13 ; 113) et de zones d'isolation (14 ; 114) entourant celle-ci sur une couche de substrat monocristalline (11 ; 111),
- le dépôt d'une série de couches (15, 16, 17 ; 115, 116, 117, 118, 119), simultanément monocristalline sur la zone collectrice (13) et polycristalline (15/1, 16/1, 17/1 ; 115/1, 116/1, 117/1, 118/1, 119/1) sur les zones d'isolation (14), la série de couches (15, 16, 17 ; 115, 116, 117, 118, 119) étant une couche de base qui est monocristalline (16 ; 116) sur la zone collectrice (13) et polycristalline (16/1 ; 116/1) sur les zones d'isolation (14 ; 114) et qui comprend, à la fois dans sa zone monocristalline et dans sa zone polycristalline (15/1, 16/1, 17/1 ; 115/1, 116,1, 117/1, 118/1, 119/1),
a) soit une couche de couverture (17, 17/1) soit
b) une combinaison de couches (117, 118, 119; 117/1, 118/1, 119/1) composée d'une couche intermédiaire (117, 117/1), d'une couche d'arrêt de gravure (118, 118/1) et d'une couche de couverture (119, 119/1),
**caractérisé par**
- dans le cas a) : le retrait uniquement partiel de la couche de couverture (17) dans une zone latérale (19), prévue pour une zone d'émetteur active, au moyen d'attaque chimique par voie humide,
- dans le cas b) : le retrait complet de la couche de couverture (119) et le retrait uniquement partiel ou complet de la couche d'arrêt de gravure (118) sans que la couche intermédiaire (117, 117/1) ne soit enlevée, dans une zone latérale, prévue pour une zone d'émetteur active, au moyen d'attaque chimique par voie humide.

2. Procédé selon la revendication 1, **caractérisé en ce qu'**on incorpore un dopage supplémentaire dans la couche de couverture (17) par le biais de la couche de base (16).

3. Procédé selon la revendication 2, **caractérisé en ce que** le dopage incorporé en sus dans la couche de couverture (17) est utilisé comme couche d'arrêt de gravure pour un premier agent d'attaque chimique par voie humide et la couche d'arrêt de gravure est au besoin partiellement retirée à l'aide d'un second agent d'attaque chimique par voie humide.

4. Procédé selon l'une quelconque des revendications précédentes, **caractérisé en ce qu'**on a intégré du carbone ou de l'oxygène dans la couche de base (16, 116) en tant qu'agent inhibiteur de diffusion pour un dopage de la base.

5. Procédé selon la variante b) de la revendication 1, **caractérisé en ce que** la couche de base (116) a un dopage de type p et la couche intermédiaire (117) adjacente à la couche de base (116) est dopée plus faiblement à une concentration inférieure à 5 x 10¹⁸ cm⁻³, **en ce que** la couche d'arrêt de gravure (118) en silicium est fabriquée avec une concentration de bore supérieure à 1,5 x 10¹⁹ cm⁻³ sur la couche intermédiaire (117), **en ce qu'**ensuite la couche de couverture sus-jacente (119) est fabriquée avec une concentration de bore inférieure à 1,5 x 10¹⁹ cm⁻³, **en ce qu'**ensuite la couche de couverture (119) et la couche d'arrêt de gravure (118) sont entièrement retirées dans la zone d'émetteur active par l'utilisation d'un masquage, **en ce qu'**ensuite on enlève une double couche et **en ce qu'**ensuite on crée un séparateur interne (122) de manière à pouvoir dégager la couche intermédiaire monocristalline (117) au moyen de la chimie par voie humide.

6. Transistor bipolaire pourvu de zones structurées sur une couche de substrat monocristalline (11 ; 111), comportant une zone collectrice et des zones d'isolation entourant celle-ci (14 ; 114) ainsi qu'une suite de couches monocristalline (15, 16, 17 ; 115, 116, 117, 118, 119) disposées au-dessus de la zone collectrice, transistor dans lequel la suite de couches monocristalline comprend une couche de base (16, 116) et soit
a) une couche de couverture sus-jacente (17 ; 119), la couche de couverture étant partiellement enlevée dans une zone d'émetteur active (19)
b) une combinaison de couches disposée sur la couche de base (116), constituée d'une couche intermédiaire (117), d'une couche d'arrêt de gravure (118) et d'une couche de couverture (119), la couche de couverture (119) étant entièrement enlevée et la couche d'arrêt de gravure (118) étant partiellement enlevée dans la zone d'émetteur active.

7. Transistor bipolaire selon la revendication 6, **caractérisé en ce que** l'épaisseur extraite de la couche de couverture (17) est comprise entre 50 nm et 200 nm.

8. Transistor bipolaire selon la revendication 6 ou 7, **caractérisé en ce que** l'épaisseur restante de la partie gravée en retrait (19) de la couche de couverture (17) est comprise entre 30 nm et 60 nm.

9. Transistor bipolaire selon l'une quelconque des revendications 6 à 8, **caractérisé en ce que** la couche de couverture (17) est entièrement ou partiellement dopée par le type de conduite de la couche de base, avec une concentration en dopants inférieure à 5 x 10¹⁸ cm⁻³.

10. Transistor bipolaire selon l'une quelconque des revendications 6 à 9, **caractérisé en ce qu'**on a incorporé du carbone ou de l'oxygène dans la couche de base (116).

11. Transistor bipolaire selon la revendication 9 ou 10, **caractérisé en ce que** l'épaisseur extraite de la couche intermédiaire (117) est comprise entre 30 nm et 60 nm.

12. Transistor bipolaire selon l'une quelconque des revendications 9 à 11, **caractérisé en ce que** la couche intermédiaire (117) est dopée par le type de conduite de la base, à une concentration en dopants inférieure à 5 x 10¹⁸ cm⁻³.

13. Transistor bipolaire selon l'une quelconque des revendications 9 à 12, **caractérisé en ce que** l'épaisseur extraite de la couche d'arrêt de gravure (118) est comprise entre 3 nm et 20 nm.

14. Transistor bipolaire selon l'une quelconque des revendications 9 à 13, **caractérisé en ce que** l'épaisseur extraite de la couche de couverture (119) est comprise entre 30 nm et 150 nm.

15. Transistor bipolaire selon l'une quelconque des revendications 9 à 14, **caractérisé en ce que** la couche d'arrêt de gravure (118) est composée de SiGe ou SiC.

16. Transistor bipolaire selon l'une quelconque des revendications 9 à 15, **caractérisé en ce que** la couche d'arrêt de gravure (118) ou la couche de couverture (119) sont composées d'une couche de silicium fortement dopée avec le type de conduite de la base.

17. Transistor bipolaire selon l'une quelconque des revendications 9 à 16, **caractérisé en ce que** la base a une conduction p et la couche d'arrêt de gravure (118) est dopée avec une concentration de bore supérieure à 1,5 x 10¹⁹ cm⁻³ et la couche de couverture avec une concentration de bore inférieure à 1,5 x 10¹⁹ cm⁻³.
